# EUROPEAN PATENT APPLICATION

(11) **EP 1 102 303 A2**
(43) Date of publication of application: **23.05.2001**
(21) Application number: 00310038.5
(22) Date of filing: 10.11.2000
(51) Int. Cl.: H01J 37/06, H01J 3/02

(54) **Electron beam columns**

(30) Priority: 10.11.1999 US 437811
(71) Applicant: Etec Systems, Inc., Hayward, CA 94545 (US)
(72) Inventor: Veneklasen, Lee H., Castro Valley, CA 94546 (US)
(74) Representative: Bayliss, Geoffrey Cyril

(57) **Abstract**

A tetrode (four electrode) gun (202) is described which allows the adjustment of both variable high brightness and illumination uniformity in the profile of the electron beam. This is achieved by providing an electrostatic focusing electrode (18) between the cathode (2) and the anode (8) within the electron gun. The focusing electrode is positively biased to a few keV and allows the image of the cathode to be focused at infinity. The addition of a focusing electrode enables both variable brightness and illumination uniformity by adjustment of the bias of a grid (4) which is mounted below the cathode to maintain constant emission, while adjusting the bias of the focusing electrode to obtain the optimal beam cross-sectional uniformity.

## Description

This invention relates to electron beam columns and to electron guns (sources) for use for instance in such columns for electron beam lithography.

Electron beam columns are well known for use, for instance, in electron beam lithography for imaging a pattern onto a substrate typically coated with a resist sensitive to an incident electron beam. Subsequent development of the exposed resist defines a pattern in the resist which later can be used as a pattern for etching or other processes. Electron beam columns are also used in electron microscopy for imaging surfaces and thin samples. Conventional electron beam columns for electron microscopy and lithography are well known and typically include an electron gun, including an electron emitter, that produces an electron beam. The electron beam from the gun may be used to produce a scanning probe, or may be used to illuminate a sample or an aperture using a series of electron beam lenses.

Both conventional electron beam columns and electron beam microcolumns include a source of electrons. In one version this source is a conventional Schottky emission gun or a field emission gun (generally referred to as electron guns) which typically includes an emitter (cathode) and a triode region surrounding the emitter downstream of which, with respect to the direction of the electron beam, is an electrostatic pre-accelerator lens that focuses and accelerates the electron beam to its final energy. As described above. this gun optics is followed by a series of lenses which refocuses and images the source aperture or sample onto the target. (Optics and lenses here refer to structures for handling and manipulation of electron beams and not to conventional light optics.)

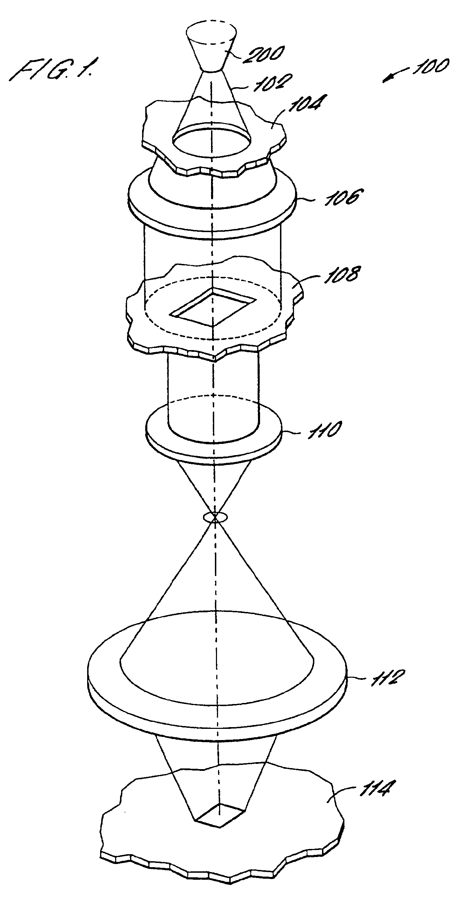

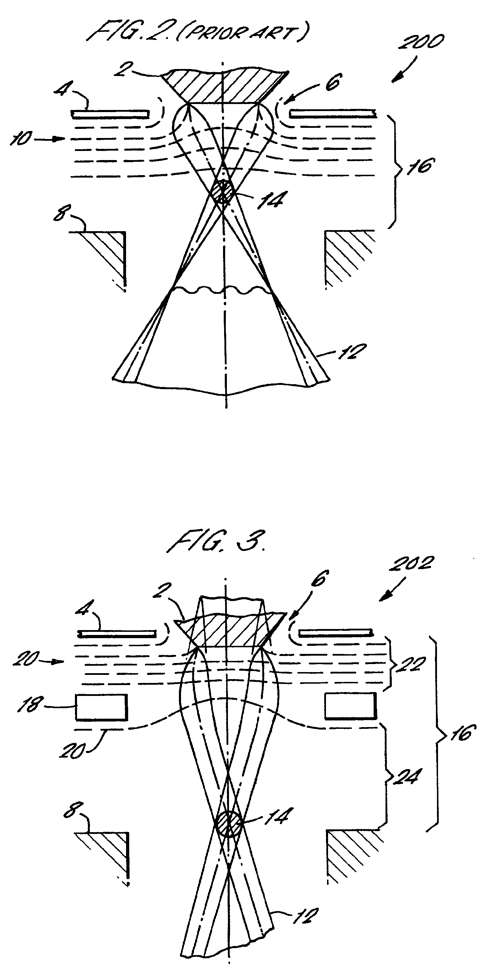

An electron gun for variable shaped beam lithography, e.g., see U.S. Pat. No. 4.430.570 which is herein incorporated by reference, requires a combination of high brightness and low energy spread for uniform shape illumination. Critical dose requirements, elaborate shapes. and the use of pattern apertures place greater demands on illumination uniformity. However, as seen in the cross section in Figure 2. conventional thermionic electron guns use triode assembly 200 with cathode 2. negatively biased grid electrode 4. and accelerating anode 8 (the rest of the electron gun including support members, electrical leads, and the vacuum enclosure are not shown). In controlling brightness in triode assembly 200. cathode temperature controls the current density from its surface, while the bias of grid 4 controls emission by limiting the area from which electron beam 12 can leave the surface of cathode 2 as it passes through grid hole 6. In conventional electron beam columns with flat lanthanum-hexaboride (LaB₆) cathodes, electron beam 12 brightness is usually limited by space charge effects, which sets an upper limit upon current density regardless of temperature of cathode 2. Space charge effects cause the spread of energy in beam 12 to increase and are well known in the art. A method of maximizing brightness is to accelerate electrons as soon as possible after they leave the surface of cathode 2. Using a reverse biased gun gives a field strength at cathode surface which is necessarily quite low; the length and radial extent of the low field region can be controlled by the gun geometry. This gives higher fields in the center of the emitting region on surface of cathode 2 and relieves space charge limitations and encourages Schottky emission, both of which increase brightness.

To control illumination uniformity, conventional electron guns use large flat cathodes in "critical illumination mode." An image of the surface of cathode 2 in Figure 2 illuminates a shaped aperture used to form the beam 12 cross-section and which is mounted well downstream of anode 8 (a shape object is well known in the art and is shown as shape object 110 in Figure 1). Here, the angular distribution of beam 12 emerging from the gun tends to give a flat "Manhattan" profile rather than a Gaussian profile, thus enabling the use of a larger fraction of emerging beam 12 to uniformly illuminate the object.

However, when variable brightness and uniformity are simultaneously required, the triode gun has fundamental problems. With such a triode assembly 200. it is not possible to achieve telefocal imaging of the surface of cathode 2 for a wide range of emission currents and cathode current densities. Lower current density implies a small emitting area on the surface of cathode 2. but the electric field configuration necessary to limit emission to this area results in excessive lens action. causing the image of cathode 2 to be small and located close to anode 8. This image should ideally be magnified and projected telecentrically onto a focal plane near infinity. Correct illumination can be obtained by adding a magnetic lens near the gun exit to project the surface image to infinity. but this magnetic lens influences the image of crossover 14, or the Fourier plane image, and also requires major modifications of the gun design and geometry and thus is not suitable for installation. Therefore, ideal illumination can only be achieved for one combination of gun bias conditions in conventional triode assembly 200.

Conventional electron guns used in electron beam columns utilize a thermionic triode (three electrode) configuration for an electron emitter. In accordance with the invention, a tetrode (four electrode) gun allows the adjustment of both variable high brightness and illumination uniformity in the profile of the electron beam. This is achieved by adding the fourth electrostatic focusing electrode located between the cathode and the anode within the electron gun. The focusing electrode is positively biased, e.g.. to a few keV and allows the image of the cathode to be focused at infinity.

The focusing electrode shields the cathode from the high electric fields generated within the gun. This enables the cathode to be placed further towards the anode than in a triode configuration; also. as electrons are emitted and transition from the low strength field of the cathode to the higher strength field of an accelerating gap. the difference in field strengths further acts as an aperture lens. Therefore, the addition of a focusing electrode enables a user to obtain both variable brightness and illumination uniformity by adjusting the bias of a grid which is mounted downstream of the cathode to maintain constant emission while adjusting the focusing electrode to obtain the optimal beam cross-sectional uniformity.

The following is a description of some specific embodiments of the invention, reference being made to the accompanying drawings in which:
Fig. 1 is a view of a conventional electron shaped beam column.
Fig. 2 is a view of a conventional triode assembly in the electron beam column of Figure 1.
Fig. 3 is a view of the present tetrode assembly in the electron beam column of Figure 1.
Fig. 4 is a diagram of the principal rays of an electron beam from a triode assembly and a plot of its corresponding equipotential energy.
Fig. 5 is a diagram of the principal rays of an electron beam from the present tetrode assembly and a plot of its corresponding equipotential energy.

Use of the same reference symbols in different figures indicates similar or identical items.

Electron beam columns as described above are well known in the art. Figure 1 is a diagram of a conventional shaped beam column 100. such as used in a conventional electron beam lithography tool (the reminder of which is not drawn) that images a focused shape, defined by an aperture. onto a substrate. Column 100 includes an electron source 200 that emits an electron beam 102 that passes via aperture 104 and electron beam lens 106. as is well understood in the art. Beam 102 is projected on shape object 108. e.g.. a square-shaped aperture. A series of electron beam lenses 110, 112, which may be magnetic lenses or electrostatic lenses. are used to focus the electrons passing through shape object 108 and project a demagnified image of shape object 108 on substrate 114. When column 100 is used in a lithography tool. substrate 114 is a mask blank or semiconductor wafer.

As shown in Figure 1, conventional shaped electron beam column 100 produces a focused image of shape object 108 on substrate 114. Typically, the size of shape object 108 used in column 100 is larger than the image of shape object 108 on substrate 114. so it is produced with a large total linear column demagnification.

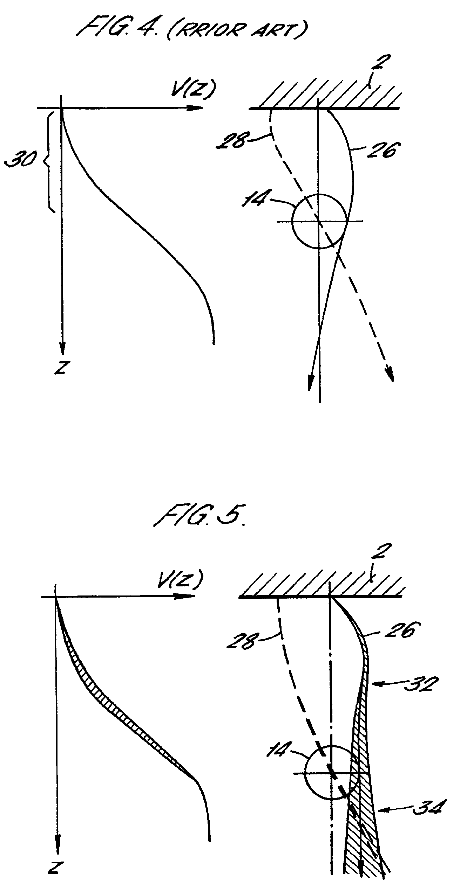

Figure 3 shows an electron gun tetrode assembly 202 for use in an electron beam column. Assembly 202 substitutes for prior art assembly 200 of Figure 2 and in most respects is similar to assembly 200 of Figure 2 (in a similar view) with similar elements identically labeled and with the addition of focusing electrode 18. diode gap 22, and accelerating gap 24. Cathode 2 and grid 4 form a "diode region" and as in triode assembly 200, the temperature of cathode 2 determines the current density at the surface of cathode 2 while grid 4 controls the emission. (The grid 4 need not be an actual grid.) However, additional focusing electrode 18 mounted below grid 4 allows an image from cathode 2 to be focused at infinity for a wider range of conditions in the diode region. With cathode 2 voltage held at 0 eV. grid 4 bias can range from -10 eV to 1000 eV and anode 8 bias can range from 50 keV to 100 keV. In one embodiment, for example, with cathode 2 potential at 0 eV, grid 4 bias is -50 eV, and anode 8 bias is 100 keV. (These values are illustrative, not limiting.) Focusing electrode 18 is electrostatic; although magnetic lenses may be used rather than focusing electrode 18 for obtaining critical illumination. three magnetic lenses would be required rather than a single focusing electrode 18. Focusing electrode 18 may be made of a material such as molybdenum having a thickness of about, e.g.. 2 mm. Also, the diameter of the hole within focusing electrode 18 through which beam 12 passes depends on the width of gaps 22, 24; but the hole can have a diameter of about. eg., 5 mm.

The addition of focusing electrode 18 allows a different configuration of tetrode assembly 202 from triode assembly 200. As in Figure 2. triode assembly 200. cathode 2 and grid 4 directly face anode 8. This configuration necessitates that cathode 2 is mounted behind grid hole 6 in order to shield it from an accelerating field in high voltage gap 16; this is done to control emission with reasonable bias voltages. As in Figure 2. the bending of equipotential lines 10 near cathode 2 creates a strong converging lens effect that causes the image at crossover 14 to appear near the exit of the gun.

The equipotential plot of axial position Z versus electron energy V(Z) in Figure 4 for prior art triode assembly 200 illustrates that in low electric field region 30 near the surface of cathode 2 there is a relatively long region of low electric field since cathode 2 is at 0 eV and grid 4 is at -50 eV in one embodiment. This low field encourages space charge effects. The bending of equipotential lines 10 creates the strong converging lens effect that focuses the image at crossover 14 near the gun exit. In tetrode assembly 202, as seen in Figure 3. grid 4 remains reverse biased; however, focusing electrode 18 is biased to only a few keV. positive. The voltage of focusing electrode 18 may actually range from 2 keV to 10 keV, but in one embodiment, for example, focusing electrode 18 bias is at 2 keV. Focusing electrode 18 shields diode gap 22 from the stronger field in accelerating gap 24, as shown by the relative straightness of equipotential lines 20 near cathode 2; this is due to anode 8 being biased at 100 keV and grid 4 being biased at -50 eV in one embodiment. This shielding enables cathode 2 to be set further forward beyond grid hole 6, which in turn allows beam 12 to remain divergent prior to entering focusing electrode 18. The widths of gaps 22.24 can vary: however, in one embodiment diode gap 22 can have a distance of about 2 mm and accelerating gap 24 can have a distance of about 10 mm. The zero volt equipotential of cathode in one embodiment limits the emitting region so the field in diode gap 22 forms a much weaker lens. The principal rays for tetrode assembly 202, seen in Figure 5 as central principal ray 26 and peripheral principal ray 28. are divergent while traversing diode gap 22 until entering focusing electrode 18. The point where beam 12 enters focusing electrode 18 is seen where central principal ray 26 kinks at inflection point 32. Leaving diode gap 22, both the images of cathode 2 and crossover 14 are virtual, i.e., they both lie behind the surface of cathode 2.

Figure 5 further illustrates that transitioning from the weaker field in diode gap 22 to the stronger field in accelerating gap 24 creates an additional focusing action; this difference in field strength forms an aperture lens. Lens changes can be effectuated by increasing the voltage in focusing electrode 18 to 2 keV; this allows the user to image the surface of cathode 2 and crossover 14 at locations downstream of tetrode assembly 202. Therefore. focusing electrode 18 allows a user to obtain both variable brightness and illumination uniformity by adjusting the bias of grid 4 to maintain constant emission. while adjusting the voltage of focusing electrode 18 to obtain optimum beam 12 uniformity. Additionally. for small changes in focusing electrode 18 voltage (on the order of a few tenth of an eV). diameter of crossover 14 remains relatively constant. further providing a semi-independent control of illumination uniformity.

In accordance with the above description, the principal rays for both triode and tetrode assemblies 200, 202, respectively, are seen in Figures 4 and 5. Figure 5 illustrates the range that principal rays 26, 28 can be controlled independently of biasing conditions near cathode 2, thus resulting in a spread in focusing variability 34. The end result is that temperature, current density, and brightness of cathode 2 can be optimized first and then optimal uniformity of beam 12 can be obtained by adjusting the voltage of focusing electrode 18.

Although the invention has been described with reference to particular embodiments, the description is only an example of the invention's application and should not be taken as a limitation. In particular, even though much of preceding discussion was aimed at applications for electron guns in lithography, alternative embodiments of this invention include use in microcolumns and for other electron beam column applications. Various other adaptations and combinations of features of the embodiments disclosed are within the scope of the invention as defined by the following claims.

## Claims

1. An electron beam column, comprising:
an electron source including:
a cathode;
an electrode disposed coaxially to electrons emitted from said cathode;
an anode disposed coaxially to said electrons influenced by said electrode;
an electrostatic focusing electrode disposed between said electrode and said anode;
an aperture located so that an electron beam from said source is incident thereon; and
a plurality of electron beam lenses, each co-axial to said electron beam and located to focus said beam after passing through said aperture.

2. An electron beam column as claimed in claim 1, wherein said cathode is biased to about 0 eV.

3. An electron beam column as claimed in claim 1 or claim 2, wherein said electrode is a grid electrode.

4. An electron beam column as claimed in any of claims 1 to 3, wherein said electrode is biased in a range of about -10 eV to 1000 eV.

5. An electron beam column as claimed in any of claims 1 to 4, wherein said anode is biased in a range of about 50 keV to 100 keV.

6. An electron beam column as claimed in any of claims 1 to 5, wherein said focusing electrode is biased in a range of about 2 keV to 10 keV.

7. An electron beam column as claimed in any of claims 1 to 6, wherein said cathode extends within an opening defined in said electrode.

8. An electron beam column as claimed in any of claims 1 to 7, wherein said focusing electrode electrically shields said cathode and said electrode.

9. An electron beam column as claimed in any of claims 1 to 8, wherein said focusing electrode has a thickness of about 2 mm.

10. An electron beam column as claimed in any of claims 1 to 9, wherein said focusing electrode is made from molybdenum.

11. An electron beam column as claimed in any of claims 1 to 10, wherein said focusing electrode defines a hole through which said electron beam passes, said hole having a diameter of about 5 mm.

12. An electron beam column as claimed in any of claims 1 to 11, wherein said focusing electrode is disposed about 2 mm from said electrode.

13. An electron beam column as claimed in any of claims 1 to 12, wherein said focusing electrode is disposed about 10 mm from said anode.

14. A method of providing an electron beam in an electron beam column, comprising said acts of:
emitting an electron beam;
subjecting said emitted beam to a first electric field coaxial with a point of said emission;
subjecting said emitted beam to a second electric field downstream from said first field;
focusing said electron beam in a third electric field downstream from said second field;
passing said focused electron beam through an aperture to shape said beam; and
passing said shaped electron beam through a plurality of electron beam lenses each coaxial to said electron beam.
